# EUROPEAN PATENT SPECIFICATION

(11) **EP 0 458 770 B1**
(45) Date of publication and mention of the grant of the patent: **06.04.1994**
(21) Application number: 91850115.6
(22) Date of filing: 03.05.1991
(51) Int. Cl.: H05K 7/20, F28F 1/10

(54) **An arrangement for convection cooling of apparatus rooms**
Vorrichtung zur Konvektionskühlung von Apparaturräumen
Arrangement pour la réfrigération de convection pour espaces des appareils

(30) Priority: 21.05.1990 SE 9001829
(43) Date of publication of application: 27.11.1991
(73) Proprietor: TELEFONAKTIEBOLAGET L M ERICSSON, 126 25 Stockholm (SE)
(72) Inventor: Forsman, Sven Bertil, S-141 38 Huddinge (SE); Wahl, Sune Erik, S-619 00 Trosa (SE)
(74) Representative: Bjellman, Lennart Olov Henrik

(56) References cited:
- SE-B- 456 449
- Ericsson Review, no. 4, 1981, p. 188-195, Ragnar Almquist: "Kylsystem för elektroniska telefonstationer"
- Ericsson Review, no. 4, 1989, p. 146-152, Johan Koltke et al.: "Kylsystem för telefonstationer - en jämförelse av olika principer"

## Description

### TECHNICAL FIELD

The present invention relates to an arrangement for cooling apparatus rooms and the like by natural convection.

### BACKGROUND ART

Satisfactory cooling of apparatus rooms, for instance in telephone exchanges, has earlier been achieved with the aid of controlled systems that comprise motor-driven fans and heat exchangers. It has been found, however, that such rooms can be cooled by natural convection, where the air heated by the apparatus flows upwards and then down through a heat exchanger, in which the air is cooled. Natural convection eliminates those operational disturbances and operating costs associated with the controlled cooling systems.

The Swedish Patent Specification No. 456449 describes a heat exchanger which is intended precisely for natural convection while utilizing a so-called chimney effect, which is achieved by virtue of an arrangement of a number of vertical channels which connect with the heat exchanger and which conduct the air flow through said heat exchanger and past the heat-exchanging fins and tubes thereof. This known arrangement, however, is intended primarily for outdoor installation, with the intention of cooling a liquid medium flowing through the heat-exchanger tubes. Other applications are also possible, of course, such as an application in which a cold medium is caused to flow through the heat-exchanger tubes so as to cool warm air flowing through the heat-exchanger.

Naturally, a heat-exchanger which is constructed for cooling purposes can also be used indoors for the purpose of cooling different electronic equipment, for instance. Convection-induced air streams are then obtained in the room concerned. Irrespective of the path travelled by these air streams or air flows, they will be subject to disturbances which reduce cooling efficiency. It is therefore desirable to be able to control these convection-induced air streams in a manner which will increase cooling efficiency.

The object of the present invention is to satisfy this desideratum and also to provide other advantages. This object is achieved with an arrangement of the kind defined in the Claims, which also set forth the significant characteristic features of the invention.

### BRIEF DESCRIPTION OF THE DRAWINGS

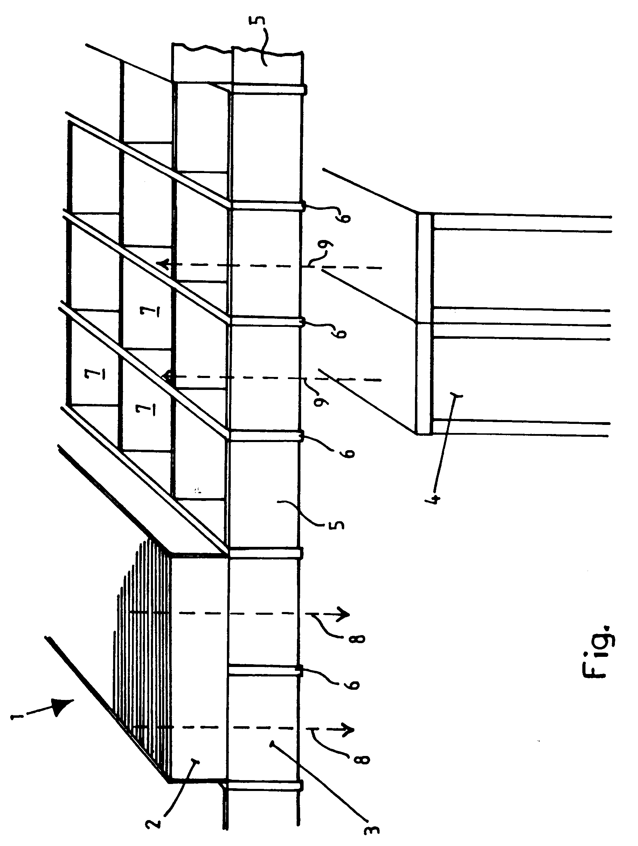

The invention will now be described in more detail with reference to the accompanying drawing, which is a schematic, perspective view of part of an arrangement constructed in accordance with the invention.

### BEST MODE OF CARRYING OUT THE INVENTION

The drawing illustrates a heat-exchanger unit 1 of the kind taught by the aforesaid Swedish Patent Specification No. 456449. This heat-exchanger unit comprises a heat-exchanger 2 and a cell structure 3 arranged therebeneath. In the illustrated embodiment, the unit 1 is placed on one side of and above an apparatus 4. The heat-exchange unit or units 1 is/are suitably placed over the corridors which run between respective rows of apparatus 4.

The object of the cell structure 3 is to generate a so-called chimney effect, i.e. to improve the natural draught through the heat-exchanger 2, and comprises wall members which extend perpendicularly to one another to form rectangular or square cells.

According to the invention, this cell structure 3 extends beyond the heat-exchanger unit 1 and there comprises mutually perpendicular wall members 5, 6 which intersect one another to form square or rectangular, through-passing open channels 7. The heat-exchanger units 1 and the whole of the cell structure 3 are suspended from the original ceiling of the apparatus room or supported in some other way. A space through which air can flow, however, is provided between the ceiling and the heat-exchanger unit 1 and cell structure 3.

The arrangement operates in a manner such that the heat-exchangers 1 are activated when cooling is necessary. The air cooled in the heat-exchangers will therewith sink down in the spaces between the apparatus 4, as indicated by the arrows 8, and the air flow is amplified by means of the chimney effect achieved with the aid of the cell structure 3 beneath the heat-exchanger 2. At the same time, air which is heated by the apparatus 4 flows upwards, as indicated by the arrows 9. This air reaches the channels 7 located in the cell structure 3 immediately above the apparatus 4, and the upwardly flowing air stream is amplified by means of the chimney effect. The inventive arrangement thus amplifies the air streams in the vertical direction thereby providing an improved cooling effect. However, the vertical air streams or flows can also be guided so as not to disturb one another and therewith create unnecessary turbulance. Thus, the heated air rises generally straight up from the apparatus 4 and into the channels 7 in the cell structure and is prevented from entering the cooled, downwardly flowing air partly by the actual walls 5, 6 themselves and partly by the increased flow obtained by the chimney effect.

A further advantage afforded by the inventive arrangement is that the original ceiling of the room to be cooled is covered by the cell structure, which imparts to the visible ceiling an attractive appearance, thereby enabling the original ceiling of the room to be given an appropriate simple and inexpensive construction.

It will be understood that although the through-passing channels 7 of the illustrated cell structure have a substantially rectangular cross-section, the channels 7 may have any suitable cross-sectional shape whatseover, e.g., a circular shape or totally irregular shape. In some instances, the aesthetic appearance of the secondary ceiling structure provided by the arrangement may decide the shape of the channel cross-section, provided that the chimney effect is achieved.

## Claims

1. An arrangement for cooling apparatus rooms by convection, in which heat-exchanger units (1) having through-flow channels which generate a chimney effect are mounted on a level above the heat-generating apparatus (4), **characterized** in that a cell structure having vertical through-flow channels (7) which generate a chimney effect is disposed on one side of the heat-exchanger unit or units (1).

2. An arrangement according to Claim 1, **characterized** in that the heat-exchanger unit or units (1) is or are positioned on one side of the heat-generating apparatus (4); and in that the cell structure having said through-flow channels (7) is positioned above said heat-generating apparatus (4).

3. An arrangement according to Claim 1 or 2, **characterized** in that the cell structure forms in the apparatus room a visible ceiling structure in the vicinity of the heat-exchanger unit or units (1) and on one side of said unit or units.

## Patentansprüche

1. Anordnung zur Konvexionskühlung von Apparaturräumen, bei der Wärmetauschereinheiten (1) mit Durchflußkanälen, die einen Kamin-Effekt erzeugen, auf einem Niveau oberhalb der Wärme-erzeugenden Apparatur (4) montiert sind,
dadurch **gekennzeichnet,** daß sich eine Zellenstruktur mit vertikalen Durchflußkanälen (7), die einen Kamin-Effekt erzeugen, auf einer Seite der Wärmetauschereinheit oder Einheiten (1) befindet.

2. Anordnung nach Anspruch 1,
dadurch **gekennzeichnet,** daß die Wärmetauschereinheit oder Einheiten (1) auf einer Seite der Wärme-erzeugenden Apparatur (4) positioniert ist oder sind; und daß die Zellenstruktur mit den Durchflußkanälen (7) oberhalb der Wärme-erzeugenden Apparatur (4) positioniert ist.

3. Anordnung nach Anspruch 1 oder 2,
dadurch **gekennzeichnet,** daß die Zellenstruktur in dem Apparaturraum eine sichtbare Deckenstruktur in der Nähe der Wärmetauschereinheit oder Einheiten (1) und auf einer Seite der Einheit oder Einheiten bildet.

## Revendications

1. Aménagement pour le refroidissement de salles d'appareillages par convection, dans lequel des unités à échangeur de chaleur (1) présentant des canaux d'écoulement libre qui génèrent un effet de cheminée sont montées à un niveau au-dessus des appareils (4) générant de la chaleur, caractérisé en ce qu'une structure cellulaire ayant des canaux verticaux (7) à écoulement libre, qui génèrent un effet de cheminée, est disposée sur un côté de l'unité ou des unités (1) à échange de chaleur.

2. Aménagement selon la revendication 1, caractérisé en ce que l'unité ou les unités (1) à échangeur de chaleur est ou sont placées sur un côté des appareils (4) générant de la chaleur ; et en ce que la structure cellulaire présentant lesdits canaux (7) à écoulement libre est placée au-dessus desdits appareils (4) générant de la chaleur.

3. Aménagement selon la revendication 1 ou 2, caractérisé en ce que la structure cellulaire forme dans la salle d'appareillage une structure visible de plafond au voisinage de l'unité ou des unités (1) à échangeur de chaleur et sur un côté de ladite unité ou desdites unités.
